# EUROPEAN PATENT APPLICATION

(11) **EP 4 848 290 A1**
(43) Date of publication of application: **02.12.2026**
(21) Application number: 26168490.6
(22) Date of filing: 27.03.2026
(51) Int. Cl.: G11C 29/00, G11C 5/02, G11C 5/06, G11C 29/52, G11C 29/04, G11C 29/42

(54) **MEMORY DEVICE INCLUDING LOGIC DIE, MEMORY STACK, AND COMMUNICATION CHANNELS, AND MEMORY SYSTEM INCLUDING MEMORY DEVICE**

(30) Priority: 30.05.2025 KR 20250071603
(71) Applicant: Samsung Electronics Co., Ltd., Suwon-si, Gyeonggi-do 16677 (KR)
(72) Inventor: KIM, Yujin, 16677 Suwon-si (KR); HAN, Jinwoo, 16677 Suwon-si (KR); KIM, Hyeoncheol, 16677 Suwon-si (KR); KIM, Juhyun, 16677 Suwon-si (KR)
(74) Representative: Marks & Clerk LLP

(57) **Abstract**

A memory device includes a logic die, a memory stack stacked on the logic die and including a plurality of core dies and a backup die electrically connected to the logic die through a plurality of through-silicon vias, and a plurality of channels configured to provide communication between the logic die and the memory stack. Each of the plurality of channels includes a plurality of sub-channels mapped to the plurality of core dies and the backup die to avoid overlapping one another.

## Description

### FIELD

Embodiments of the present disclosure relate to a memory device and more particularly to a memory device including a logic die, a memory stack, and communication channels, and to a memory system including a memory device.

### BACKGROUND

The development of semiconductor technology has led to a growing demand for high integration and high performance in semiconductor device packaging. Accordingly, in addition to a two-dimensional (2D) structure in which semiconductor chips with integrated circuits are mounted on a printed circuit board using wires or bumps, various technologies for a three-dimensional (3D) structure in which semiconductor chips are vertically stacked are being developed.

A 3D structure may be implemented through various die stacking technologies. For example, semiconductor chips may be three-dimensionally stacked using methods such as Chip-on-Wafer (CoW) or Wafer-on-Wafer (WoW). However, the CoW method has a relatively low bonding yield, and the WoW method is unable to select and stack a Known Good Die (KGD). When a bad die is stacked in a 3D structure, the entire die stack may be considered defective.

### SUMMARY

According to one or more embodiments, a memory device includes a logic die, a memory stack stacked on the logic die and including a plurality of core dies and a backup die electrically connected to the logic die through a plurality of through-silicon vias, and a plurality of channels configured to provide communication between the logic die and the memory stack. Each of the plurality of channels includes a plurality of sub-channels mapped to the plurality of core dies and the backup die to avoid overlapping one another i.e. each sub-channel of the plurality of sub-channels is mapped to a different core die of the plurality of core dies or to the backup die so that no two sub-channels of the plurality of sub-channels are mapped to the same core die or to the backup die.

According to one or more embodiments, a memory system includes a host device configured to generate data and a command address, and a memory device configured to receive the data and the command address from the host device. The memory device includes: a logic die; a memory stack stacked on the logic die and including a plurality of core dies and a backup die electrically connected to the logic die through a plurality of through-silicon vias; and a plurality of channels configured to provide communication between the logic die and the memory stack. Each of the plurality of channels includes a plurality of sub-channels mapped to the plurality of core dies and the backup die to avoid overlapping one another i.e. each sub-channel of the plurality of sub-channels is mapped to a different core die of the plurality of core dies or to the backup die so that no two sub-channels of the plurality of sub-channels are mapped to the same core die or to the backup die.

According to one or more embodiments, a memory device includes a logic die, a plurality of memory stacks, each memory stack including a plurality of core dies and a backup die stacked on the logic die, and a plurality of channels configured to provide communication between the logic die and the memory stacks. Each of the plurality of channels may include a plurality of sub-channels mapped to the plurality of memory stacks, and mapped to the plurality of core dies and the backup die to avoid overlapping one another i.e. each sub-channel of the plurality of sub-channels is mapped to a different core die of the plurality of core dies or to the backup die so that no two sub-channels of the plurality of sub-channels are mapped to the same core die or to the backup die.

At least some of the above and other features of the invention are set out in the claims.

### BRIEF DESCRIPTION OF THE DRAWINGS

FIG. 1 is a perspective view of a memory device according to one or more embodiments.
FIG. 2 is a diagram illustrating an area A1 of the memory device of FIG. 1.
FIG. 3 is a diagram illustrating an example of FIG. 2.
FIG. 4 is a perspective view of a memory device including a plurality of memory stacks according to one or more embodiments.
FIG. 5 is a diagram illustrating an area A2 of the memory device of FIG. 4.
FIG. 6 is a diagram illustrating an example of FIG. 5.
FIG. 7 is a block diagram of a logic die according to one or more embodiments.
FIG. 8 is a diagram illustrating the A1 area of the memory device of FIG. 1 according to one or more embodiments.
FIG. 9 is a cross-sectional view of a memory device based on hybrid copper bonding (HCB) according to one or more embodiments.
FIG. 10 is a diagram illustrating a memory system according to one or more embodiments.

### DETAILED DESCRIPTION

The following description with reference to the accompanying drawings is provided to assist in a comprehensive understanding of various embodiments of the present disclosure.

Embodiments of the present disclosure provide a memory device including a plurality of distributed sub-channels for stacked dies, and a memory system including the same.

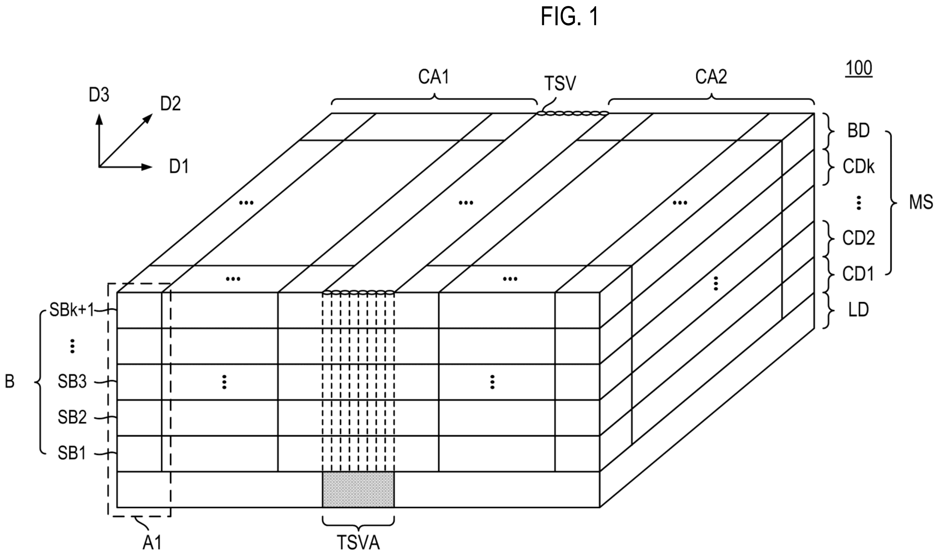

FIG. 1 is a perspective view of a memory device according to one or more embodiments.

Referring to FIG. 1, a memory device 100 according to one or more embodiments includes a logic die LD and a memory stack MS.

The logic die LD may also be referred to as a buffer die or a base die. The logic die LD may be connected to the memory stack MS and may be configured to perform data input/output between the memory stack MS and a host device, or provide an access to the memory stack MS to the host device.

For example, the logic die LD may be one of a gate array, a cell base array, an embedded array, a structured application-specific integrated circuit (ASIC), a field programmable gate array (FPGA), a complex programmable logic device (CPLD), a central processing unit (CPU), a microprocessing unit (MPU), a microcontroller unit (MCU), a logic IC, an application processor (AP), a driver IC, a radio-frequency (RF) chip, and a complementary metal-oxide-semiconductor (CMOS) image sensor. However, embodiments are not limited thereto, and the logic die LD may be a memory chip.

A through-silicon via (TSV) area TSVA may be formed in the logic die LD. A plurality of TSVs may be disposed in the TSV area TSVA formed in the logic die LD. The plurality of TSVs may be configured to have various numbers according to embodiments.

In one or more embodiments, the TSV area TSVA may be disposed between a first cell area CA1 and a second cell area CA2 with respect to a first axis D1.

The memory stack MS may include a plurality of core dies CD1 to CDk and a backup die BD stacked on the logic die LD. In one or more embodiments, the number of the plurality of core dies CD1 to CDk may be k (where k is a positive integer greater than or equal to 2).

In one or more embodiments, the backup die BD may be uniquely configured for each memory stack MS. For example, when a plurality of memory stacks MS1 and MS2 are configured, a single backup die BD may be configured for each of the plurality of memory stacks MS1 and MS2.

Each of the plurality of core dies CD1 to CDk and the backup die BD may include a plurality of sub-banks. Each sub-bank may include a plurality of memory cells connected to a plurality of wordlines and bitlines, a row decoder, a column decoder, a sense amplifier, or the like.

The plurality of sub-banks may be configured on the first cell area CA1 and the second cell area CA2 along the first axis D1 and a second axis D2 for each core die and the backup die BD.

In one or more embodiments, a first sub-bank to a k+1-th sub-bank SB1 to SBk+1 defined for each of the plurality of core dies CD1 to CDk and the backup die BD along a third axis D3 in the memory stack MS may form a single bank B. For example, the bank B may be defined along the third axis D3 in the memory stack MS. According to one or more embodiments, a plurality of banks B may be configured in a memory device.

The plurality of core dies CD1 to CDk and the backup die BD may be electrically connected to the logic die LD through the plurality of TSVs. The plurality of core dies CD1 to CDk and the backup die BD may communicate with the logic die LD through the plurality of TSVs. The plurality of core dies CD1 to CDk and the backup die BD may be configured to perform a memory operation (for example, a read operation, a write operation, or the like) based on a signal (for example, data and/or a command address) received from the logic die LD.

In one or more embodiments, the backup die BD may have different purposes depending on whether a defect occurs in the memory stack MS.

In one or more embodiments, when one of the plurality of core dies CD1 to CDk is determined to be in a bad state, the backup die BD may operate as an error correction die (for example, an error correction code (ECC) die or a parity die). For example, when a defect is determined to have occurred in the memory stack MS, the backup die BD may store error correction data such as parity or ECC.

In one or more embodiments, the determination of a bad state may be based on a fail-bit count. For example, one of the plurality of core dies CD1 to CDk may be determined to be in a bad state when the fail-bit count is greater than or equal to a set value.

In one or more embodiments, when the memory stack MS is normal, i.e. when none of the plurality of core dies CD1 ... CDk are determined to be in a bad state, the backup die BD may store at least one of user data (or normal data) or error correction data. For example, when all of the plurality of core dies CD1 to CDk are determined to be normal, i.e. when none of the plurality of core dies CD1 ... CDk are determined to be in a bad state, the backup die BD may store at least one of the user data or the error correction data.

According to the above-described embodiments, when one or more core dies of the memory device 100 are determined to be in a bad state, the backup die may operate as an ECC die storing error correction data. Accordingly, even when a defect occurs (for example, a bad die is bonded, or the like), chip-kill ECC-level error correction may be performed through the backup die.

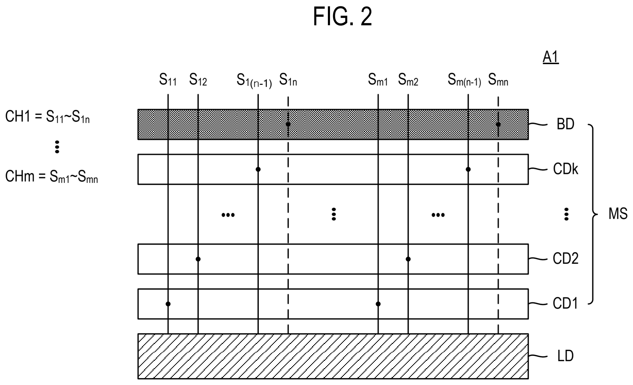

FIG. 2 is a diagram illustrating an area A1 of the memory device of FIG. 1.

Referring to FIG. 2, the memory device may include a logic die LD and a memory stack MS including a plurality of core dies CD1 to CDk and a backup die BD. In the memory device in the A1 area, the memory stack MS may correspond to a bank. Hereinafter, a detailed description of the components overlapping with those described above will be omitted to avoid redundancy.

The memory device includes a plurality of channels CH1 to CHm. Each channel may be defined as a logical and/or physical path unit through which a signal is transmitted within the memory device. Each channel may be configured or operate independently. Each channel may be defined to include an independent data bus, a command address bus, or an interface. Each channel may have an input/output width. The input/output width may be set to various values (for example, 64 bits, 128 bits, or the like).

The plurality of channels CH1 to CHm may be configured to provide communication between the plurality of core dies CD1 to CDk, and the backup die BD and the logic die LD.

In one or more embodiments, the number of the plurality of channels CH1 to CHm in the A1 area (for example, a single bank) may be m (where m is a positive integer greater than or equal to 2). Therefore, from the perspective of the memory device of FIG. 1, m x i channels may be configured (where i is the number of banks B and is a positive integer greater than or equal to 2).

In one or more embodiments, each of the plurality of channels CH1 to CHm may include a plurality of sub-channels. The number of the plurality of sub-channels configured for each channel may be n (where n is a positive integer greater than or equal to 2). For example, a first channel may include n sub-channels S₁₁ to S₁ₙ, and an m-th channel may include n sub-channels Sₘ₁ to Sₘₙ.

The plurality of sub-channels may be mapped to the plurality of core dies CD1 to CDk and the backup die BD, avoiding overlap i.e. so that no two sub-channels of the plurality of sub-channels are mapped to the same core die or to the backup die. Accordingly, the plurality of channels CH1 to CHm may all be mapped to all dies within the memory stack MS through a plurality of sub-channels included in each. In the present application, "a channel or a sub-channel is mapped to a die" may mean that each channel or sub-channel may transmit data, a command, and/or an address from the mapped die, or may mean that an input/output line allocated to each channel or sub-channel is electrically connected to the mapped die.

From the perspective of the plurality of sub-channels, each sub-channel may be mapped to one of all the dies in the memory stack MS, avoiding overlap i.e. so that no two sub-channels of the plurality of sub-channels are mapped to the same die in the memory stack MS. Accordingly, within a single channel, each sub-channel may be uniquely mapped to a single die in the memory stack MS.

A sum of the input/output widths of the plurality of sub-channels may have an input/output width, smaller than an input/output width of each channel of the plurality of channels CH1 to CHm. A sum of the input/output widths of the plurality of sub-channels may be the same as the input/output width of the single channel including the plurality of sub-channels.

An input/output width of each of the plurality of sub-channels may be defined based on the number of the plurality of core dies CD1 to CDk. For example, when the number of the plurality of core dies CD1 to CDk is j (where j is a positive integer greater than or equal to 2), an input/output width of a single sub-channel may have a value obtained by dividing the input/output width of the single channel by j. Accordingly, an input/output width of a channel per die may be configured more finely through the plurality of sub-channels. For example, when the number of the plurality of core dies CD1 to CDk is 4 and the input/output width of the channel is 64, the input/output width of the single sub-channel is 16.

As a result, a single channel may uniformly distribute and transmit a signal through the sub-channels mapped to all the dies. For example, when a single channel corresponds to DQ, channel data transmitted through a DQ interface may be distributed and transmitted through the sub-channels mapped to all the dies.

A channel may divide and transmit a signal through the plurality of sub-channels. The plurality of sub-channels may transmit data divided from data allocated to one of the plurality of channels CH1 to CHm. For example, data of each channel may be spread to the plurality of sub-channels.

In one or more embodiments, when the backup die BD stores error correction data, one of the plurality of sub-channels may transmit the error correction data to the logic die LD. For example, when the backup die BD operates as an ECC die as a defect occurs in the memory stack MS, a single sub-channel mapped to the backup die BD, among the sub-channels within a single channel, may transmit error correction data to the logic die LD. From the perspective of the plurality of channels CH1 to CHm, the error correction data may be transmitted to the logic die LD through the mapped sub-channels.

According to one or more embodiments, as a plurality of sub-channels are configured for each channel, data allocated to a single channel may be distributed and transmitted to the dies in the memory stack MS. Accordingly, even when one or more dies in the memory stack MS are determined to be in a bad state (or even when a bad die is already bonded in the memory stack MS), channel data may be transmitted through the remaining normal dies.

In addition, when one or more dies are determined to be in a bad state, the backup die may operate as an ECC die storing error correction data, so that chip-kill ECC-level error correction may be performed.

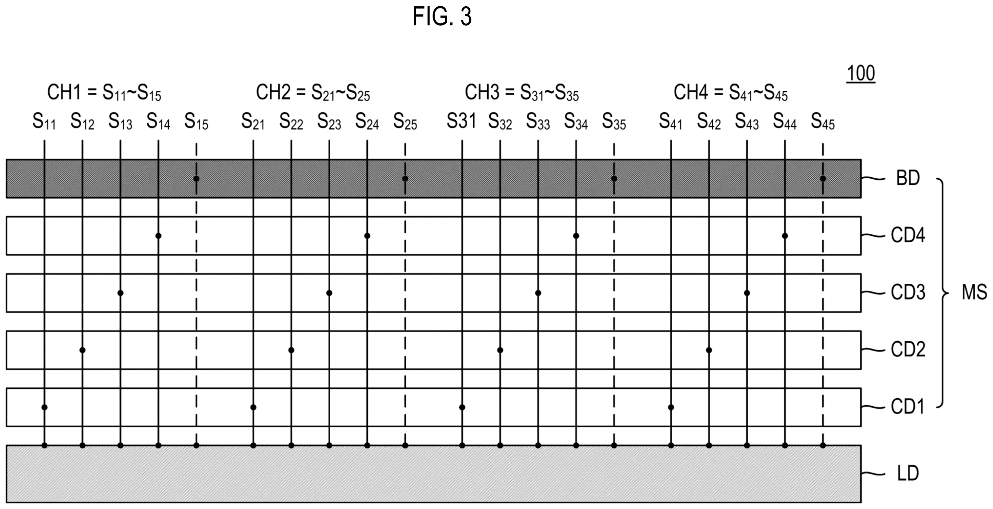

FIG. 3 is a diagram illustrating an example of FIG. 2.

Referring to FIG. 3, in one or more embodiments, four core dies and one backup die BD may be configured in the memory stack MS, and four channels may be allocated to the A area of FIG. 1. A first channel CH1 includes a (1-1)-th sub-channel to a (1-5)-th sub-channel S₁₁ to S₁₅, a second channel CH2 includes a (2-1)-th sub-channel to a (2-5)-th sub-channel S₂₁ to S₂₅, a third channel CH3 includes a (3-1)-th sub-channel to a (3-5)-th sub-channel S₃₁ to S₃₅, and a fourth channel CH4 includes a (4-1)-th sub-channel to a (4-5)-th sub-channel S₄₁ to S₄₅.

The number of core dies is 4, so that the number of sub-channels mapped to the core dies for each channel is also 4. In addition, a single sub-channel mapped to the backup die BD is also configured for each channel.

For example, within the first channel CH1, a (1-1)-th sub-channel S₁₁ may transmit a signal between a first core die CD1 and the logic die LD, a (1-2)-th sub-channel S₁₂ may transmit a signal between a second core die CD2 and the logic die LD, a (1-3)-th sub-channel S₁₃ may transmit a signal between a third core die CD3 and the logic die LD, and a (1-4)-th sub-channel S₁₄ may transmit a signal between a fourth core die CD4 and the logic die LD.

A (1-5)-th sub-channel S₁₅ may transmit a signal between the backup die BD and the logic die LD. When the backup die BD is allocated as an ECC die, the signal transmitted through the (1-5)-th sub-channel S₁₅ is error correction data. Alternatively, when the backup die BD is allocated as a normal die, the signal transmitted through the (1-5)-th sub-channel S₁₅ may be at least one of user data or error correction data.

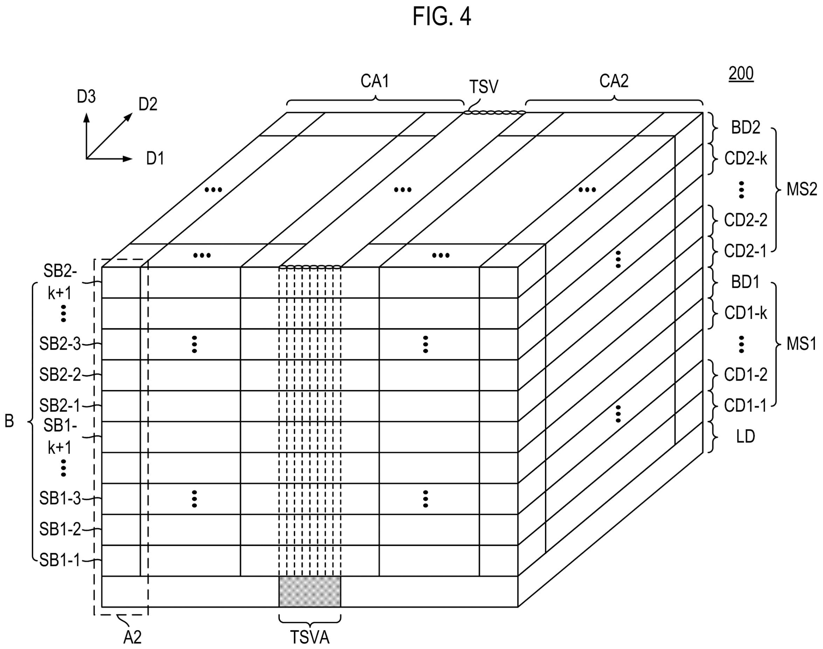

FIG. 4 is a perspective view of a memory device including a plurality of memory stacks according to one or more embodiments.

Referring to FIG. 4, a memory device 200 according to one or more embodiments may include a logic die LD and a plurality of memory stacks MS1 and MS2. For clarity, the memory device 200 of FIG. 4 is illustrated as including a first memory stack MS1 and a second memory stack MS2, but embodiments are not limited thereto. For example, the memory device 200 may include three or more memory stacks according to embodiments.

The logic die LD may be connected to the first memory stack MS1 and the second memory stack MS2 and may be configured to perform data input/output between the first memory stack MS1 and the second memory stack MS2 and a host device, or to provide an access to the first memory stack MS1 and the second memory stack MS2 to the host device.

In the TSV area TSVA configured on the logic die LD, a plurality of TSVs may be disposed to electrically connect the first memory stack MS1, the second memory stack MS2, and the logic die LD.

The memory stacks MS may include the first memory stack MS1 and the second memory stack MS2. According to one or more embodiments, when a plurality of memory stacks are configured, each of the plurality of memory stacks MS1 and MS2 may be identified through a stack ID SID. For example, different SIDs may be allocated to the memory stacks. An address transmitted through the plurality of TSVs may include the SID in addition to a bank B, a column, and a row information.

Each of the first memory stack MS1 and the second memory stack MS2 may include a plurality of core dies and a backup die stacked on the logic die LD. The first memory stack MS1 may include a (1-1)-th core die to a (1-k)-th core die CD1-1 to CD1-k and a first backup die BD1, and the second memory stack MS2 includes a (2-1)-th core die to a (2-k)-th core die CD2-1 to CD2-k and a second backup die BD2.

A backup die may be uniquely configured for each of the first memory stack MS1 and the second memory stack MS2. For example, the backup die may be uniquely configured for an SID.

For each memory stack MS, each of the plurality of core dies and a backup die may include a plurality of sub-banks.

In one or more embodiments, a (1-1)-th sub-bank to a (1-k+1)-th sub-bank SB1-1 to SB1-k+1 defined for each of the plurality of core dies CD1-1 to CD1-k and a first backup die BD1 along a third axis D3 in the first memory stack MS1 and a (2-1)-th sub-bank to a (2-k+1)-th sub-bank SB2-1 to SB2-k+1 defined for each of the plurality of core dies CD2-1 to CD2-k and a second backup die BD2 along the third axis D3 in the second memory stack MS2 may form a single bank B. For example, when a plurality of memory stacks are present, a bank B may be defined for the memory stacks along the third axis D3.

In one or more embodiments, the backup dies may have different purposes depending on whether a defect occurs in each memory stack.

For example, when one of the plurality of core dies CD1-1 to CD1-k in the first memory stack MS1 is determined to be in a bad state, the first backup die BD1 may operate as an error correction die. For example, when a defect is determined to have occurred in the first memory stack MS1, the first backup die BD1 may store error correction data.

For example, when one of the plurality of core dies CD2-1 to CD2-k in the second memory stack MS2 is determined to be in a bad state, the second backup die BD2 may operate as an error correction die. For example, when a defect is determined to have occurred in the second memory stack MS2, the second backup die BD2 may store error correction data.

In one or more embodiments, the determination of a bad state may be based on the fail-bit count and may be performed for each memory stack.

In one or more embodiments, when each memory stack is normal, i.e. when none of the plurality of core dies CD1-1 ... CD1-k of the first memory stack MS1 are determined to be in a bad state and none of the plurality of core dies CD2-1 ... CD2-k of the second memory stack MS2 are determined to be in a bad state, each backup die may store at least one of user data (or normal data) or error correction data.

For example, when all of the core dies CD1-1 to CD1-k in the first memory stack MS1 are determined to be normal, i.e. when none of the core dies CD1-1 to CD1-k in the first memory stack MS1 are determined to be in a bad state, the first backup die BD1 may store at least one of user data (or normal data) or error correction data.

For example, when all of the core dies CD2-1 to CD2-k in the second memory stack MS2 are determined to be normal, i.e. when none of the core dies CD2-1 to CD2-k in the second memory stack MS2 are determined to be in a bad state, the second backup die BD2 may store at least one of user data (or normal data) or error correction data.

According to the above-described embodiments, when one or more dies are determined to be in a bad state, the backup die may operate as an ECC die storing error correction data, so that chip-kill ECC-level error correction may be performed.

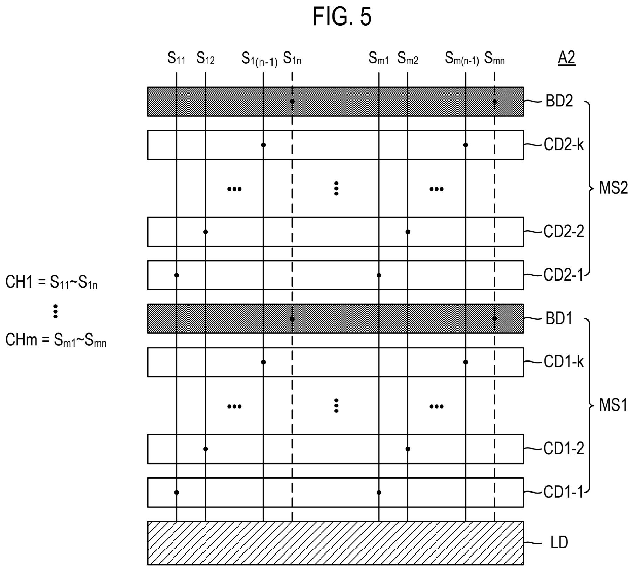

FIG. 5 is a diagram illustrating an area A2 of the memory device of FIG. 4.

Referring to FIG. 5, the memory device may include a logic die LD, a first memory stack MS1, and a second memory stack MS2.

The plurality of channels CH1 to CHm may be configured to provide communication between the logic die LD, and the first memory stack MS1 and the second memory stack MS2.

In one or more embodiments, m channels may be configured in the A2 area (for example, in a single bank). Each channel may be mapped to both the first memory stack MS1 and the second memory stack MS2.

In one or more embodiments, each of the plurality of channels CH1 to CHm may include a plurality of sub-channels. The number of the plurality of sub-channels configured for each channel may be n.

According to one or more embodiments, when a plurality of memory stacks MS are configured, the plurality of sub-channels may be mapped to each of the plurality of memory stacks MS1 and MS2. For example, n sub-channels S₁₁ to S₁ₙ included in a first channel CH1 may be mapped to each of the first memory stack MS1 and the second memory stack MS2. Similarly, n sub-channels Sm1 to Smn included in an m-th channel CHm may also be mapped to each of the first memory stack MS1 and the second memory stack MS2.

The plurality of sub-channels may be mapped to a core die and a backup die in a single memory stack, avoiding overlap i.e. so that no two sub-channels of the plurality of sub-channels are mapped to the same core die or to the backup die in a single memory stack. For example, n sub-channels S₁₁ to S₁ₙ included in the first channel CH1 may be mapped to a (1-1)-th core die to a (1-k)-th core die CD1-1 to CD1-k and a first backup die BD1 included in the first memory stack MS1, avoiding overlap and may be mapped to a (2-1)-th core die to a (2-k)-th core die CD2-1 to CD2-k and a second backup die BD2 included in the second memory stack MS2, avoiding overlap.

An input/output width of each of the plurality of sub-channels may be defined based on the number of the plurality of core dies included in the entire memory stacks. For example, when the number of all of the plurality of core dies included in the first memory stack MS1 and the second memory stack MS2 is j, an input/output width of a single sub-channel may have a value obtained by dividing the input/output width of a single channel by j. Accordingly, an input/output width of a channel per die may be configured more finely through the plurality of sub-channels.

For example, when the number of the plurality of core dies is 8 and the input/output width of the channel is 64, the input/output width of the single sub-channel is 8.

The channel may divide and transmit a signal through the plurality of sub-channels. For example, n sub-channels S₁₁ to S₁ₙ included in the first channel CH1 may divide and transmit a signal for the first memory stack MS1, and may divide and transmit a signal for the second memory stack MS2.

In one or more embodiments, when at least one of the first backup die BD1 or the second backup die BD2 stores error correction data, one of the plurality of sub-channels may transmit the error correction data to the logic die LD. For example, a sub-channel S1n of the first channel CH1 may transmit error correction data from at least one of the first backup die BD1 or the second backup die BD2 to the logic die LD.

According to one or more embodiments, as a plurality of sub-channels are configured for each channel, data allocated to a single channel may be distributed and transmitted to the dies in each memory stack. Accordingly, even when one or more dies in each memory stack are determined to be in a bad state (or even when a bad die is already bonded in a memory stack), channel data may be transmitted through the remaining normal dies.

In addition, when one or more dies are determined to be in a bad state in each memory stack, the backup die may operate as an ECC die storing error correction data, so that chip-kill ECC-level error correction may be performed for each memory stack.

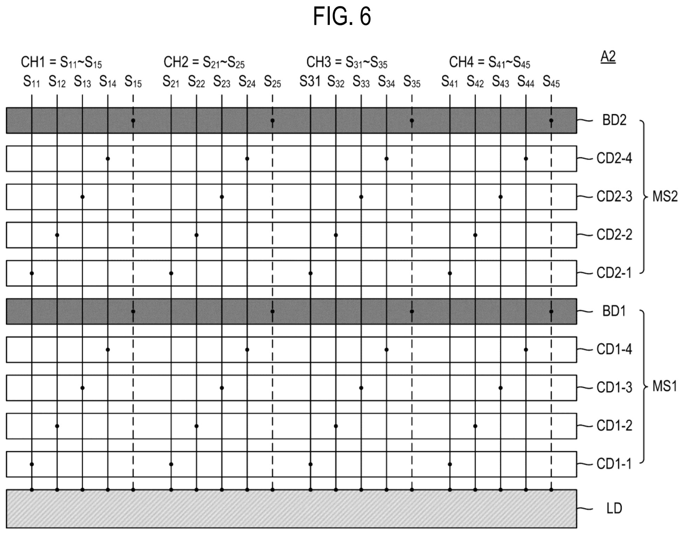

FIG. 6 is a diagram illustrating an example of FIG. 5.

Referring to FIG. 6, in one or more embodiments, four core dies and one backup die are configured for each memory stack, and four channels may be allocated to the A2 area of FIG. 4. A first channel CH1 includes a (1-1)-th sub-channel to a (1-5)-th sub-channel S₁₁ to S₁₅, a second channel CH2 includes a (2-1)-th sub-channel to a (2-5)-th sub-channel S₂₁ to S₂₅, a third channel CH3 includes a (3-1)-th sub-channel to a (3-5)-th sub-channel S₃₁ to S₃₅, and a fourth channel CH4 includes a (4-1)-th sub-channel to a (4-5)-th sub-channel S₄₁ to S₄₅.

The number of core dies included in a single memory stack is 4, so that the number of sub-channels mapped to the core dies for each channel is also 4. In addition, a single sub-channel mapped to the backup die is also configured for each channel.

Each sub-channel may be mapped to both the first memory stack MS1 and the second memory stack MS2. For example, within the first channel CH1, a (1-1)-th sub-channel S₁₁ may transmit a signal between a (1-1)-th core die CD1-1, and a (2-1)-th core die CD2-1 and the logic die LD, a (1-2)-th sub-channel S₁₂ may transmit a signal between a (1-2)-th core die CD1-2, and a (2-2)-th core die CD2-2 and the logic die LD, a (1-3)-th sub-channel S₁₃ may transmit a signal between a (1-3)-th core die CD1-3, and a (2-3)-th core die CD2-3 and the logic die LD, and a (1-4)-th sub-channel S₁₄ may transmit a signal between a (1-4)-th core die CD1-4, and a (2-4)-th core die CD2-4 and the logic die LD.

A (1-5)-th sub-channel S₁₅ may transmit a signal between a first backup die BD1, a second backup die BD2, and the logic die LD. When at least one of the first backup die BD1 or the second backup die BD2 is allocated as an ECC die, the signal transmitted through the (1-5)-th sub-channel S₁₅ may include error correction data. Alternatively, when at least one of the first backup die BD1 or the second backup die BD2 is allocated as a normal die, the signal transmitted through the (1-5)-th sub-channel S₁₅ may be at least one of user data or error correction data.

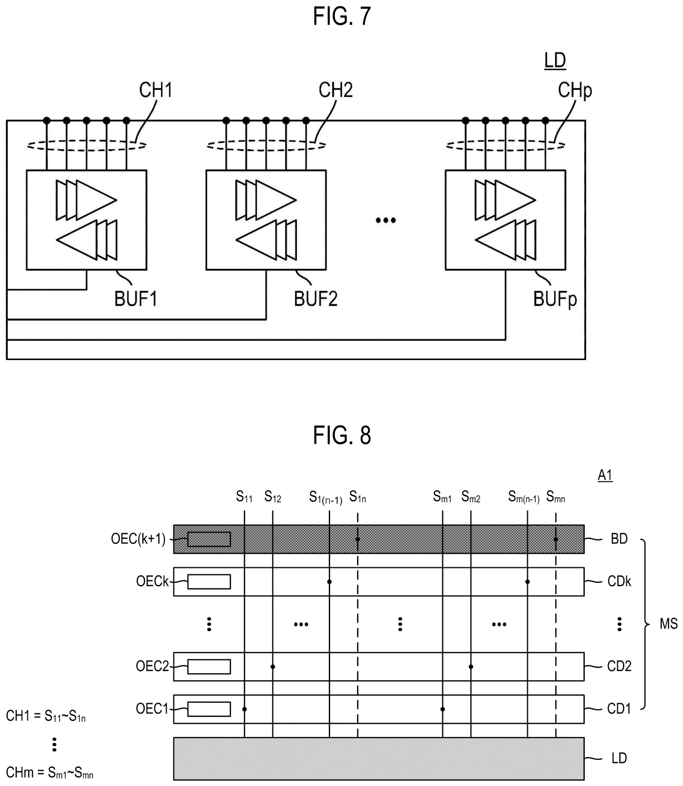

FIG. 7 is a block diagram of a logic die according to one or more embodiments.

Referring to FIG. 7, the logic die LD according to one or more embodiments may include a plurality of buffer circuits BUF1 to BUFp.

The plurality of buffer circuits BUF1 to BUFp may be configured in a number corresponding to the total number of channels configured in each memory device according to the above-described embodiments. Each buffer circuit may be configured for each channel. For example, a first buffer circuit BUF1 may be connected to a first channel CH1, and a p-th buffer circuit BUFp may be connected to a p-th channel CHp (where p is a positive integer greater than or equal to 2).

Each buffer circuit may buffer data transmitted from a memory stack through each channel, or may buffer data transmitted from a host device.

In one or more embodiments, each buffer circuit may include one or more buffers for signal transmission from the host device to the memory stack, and one or more buffers for signal transmission from the memory stack to the host device. Alternatively, each buffer circuit may include one or more buffers configured for at least one of data, a command, or an address.

Each buffer circuit is configured in each channel, so that the plurality of sub-channels included in each channel may be connected to each buffer circuit. For example, the plurality of sub-channels included in the first channel CH1 may be connected to the first buffer circuit BUF1, and the plurality of sub-channels included in the p-th channel CHp may be connected to the p-th buffer circuit BUFp. Accordingly, a single channel may be connected to a single buffer circuit on a one-to-one basis, and the plurality of sub-channels included in the single channel may be connected to the single buffer circuit on an n-to-one basis.

According to one or more embodiments, the plurality of sub-channels are mapped to the plurality of core dies and the backup die included in each memory stack, avoiding overlap so that no two sub-channels of the plurality of sub-channels are mapped to the same core die or to the backup die included in each memory stack. Therefore, a buffer circuit connected to a single channel may buffer data output from all the dies in the memory stack.

In one or more embodiments, each buffer circuit may include as many buffers as the number of sub-channels. For example, a first buffer circuit connected to a first channel may include five buffers. However, this is only an example, and the number of sub-channels or the number of buffers is not limited thereto.

FIG. 8 is a diagram illustrating the A1 area of the memory device of FIG. 1 according to one or more embodiments.

Referring to FIG. 8, the memory device according to one or more embodiments may include a plurality of on-die error correction circuits OEC1 to OEC(k+1). For example, a plurality of core dies CD1 to CDk and a backup die BD included in the memory device may each include an on-die error correction circuit.

The plurality of on-die error correction circuits OEC1 to OEC(k+1) may be configured to perform error detection and/or error correction for each die. In one or more embodiments, the plurality of on-die error correction circuits OEC1 to OEC(k+1) may be configured to perform error correction when a fail-bit count is greater than or equal to a set value. For example, when a fail-bit count for a die (a core die or a backup die BD) is greater than or equal to a set value, the on-die error correction circuit operates first. The on-die error correction circuit may attempt to correct an error for the corresponding die based on error correction data.

When error correction through the on-die error correction circuit fails, a die corresponding to the on-die error correction circuit is determined to be in a bad state. The error correction is unable to be performed using only the on-die error correction circuit, so that the backup die BD may operate as an ECC die. For example, the backup die BD may store error correction data.

For example, when a fail-bit count for a first core die CD1 is greater than or equal to a set value, a first on-die error correction circuit OEC1 may attempt to correct an error for the first core die CD1. When the error correction fails, the backup die BD may store error correction data. The backup die BD may transmit the error correction data to an external host device, and the host device may attempt to correct an error for the first core die CD1. For example, the host device may receive error correction data from the memory device and may correct an error for one or more dies based on the error correction data.

The configuration and operation of the on-die error correction circuits OEC1 to OEC(k+1) according to the above-described embodiments may be applied equivalently even when a plurality of memory stacks MS are configured. For example, when a plurality of memory stacks are configured (for example, see FIGS. 4-6), an on-die error correction circuit may be configured for each die included in each memory stack.

The memory device according to the above-described embodiments may provide an improved error correction capability by using the backup die BD as an ECC die when error correction fails through the on-die error correction circuits OEC1 to OEC(k+1).

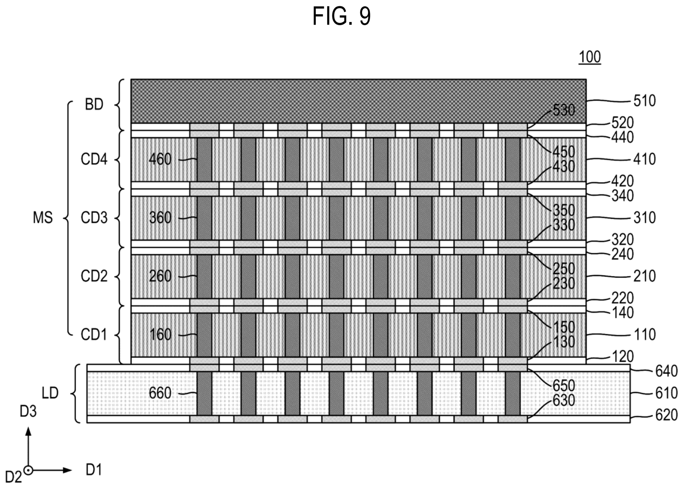

FIG. 9 is a cross-sectional view of a memory device based on hybrid copper bonding (HCB) according to one or more embodiments.

In FIG. 9, for clarity, a single memory stack MS is illustrated as being included in a memory device 100, but embodiments are not limited thereto.

A logic die in the form of a buffer die LD may include a buffer substrate 610, a buffer lower insulating layer 620, a buffer lower pad 630, a buffer upper insulating layer 640, a buffer upper pad 650, and a buffer through-silicon via 660.

For example, the buffer substrate 610 may include a semiconductor material such as silicon (Si) and germanium (Ge). In addition, the buffer substrate 610 may include a compound such as silicon carbide (SiC), gallium arsenide (GaAs), indium arsenide (InAs), or indium phosphide (InP).

For example, the buffer substrate 610 may have a silicon-on-insulator (SOI) structure and may include a buried oxide layer. The buffer substrate 610 may include a doped region doped with impurities and may have an isolation structure such as a shallow trench isolation (STI).

The buffer substrate 610 may include an electronic device. For example, the buffer substrate 610 may include a metal-oxide-semiconductor field effect transistor (MOSFET) such as a complementary metal-insulator-semiconductor (CMOS) transistor, a large scale integration (LSI), a flash memory, a dynamic random-access memory (DRAM), a static random-access memory (SRAM), an electrically erasable programmable read-only memory (EEPROM), a phase-change random-access memory (PRAM), a magnetic random-access memory (MRAM), or a resistive random-access memory (ReRAM), an image sensor such as a CMOS Imaging Sensor (CIS), a micro-electro-mechanical system (MEMS), an active device, a passive device, or the like.

The buffer substrate 610 may include a wiring structure for electrically connecting a plurality of electronic devices. The buffer substrate 610 may have a lower surface and an upper surface opposing one another. For example, the upper surface and the lower surface may refer to surfaces opposing one another with respect to a third direction D3.

The buffer lower insulating layer 620 may be disposed on the lower surface of the buffer substrate 610. A buffer upper insulating layer 640 may be disposed on the upper surface of the buffer substrate 610.

The buffer lower insulating layer 620 and the buffer upper insulating layer 640 may include an insulating material. For example, the buffer lower insulating layer 620 and the buffer upper insulating layer 640 may include at least one of silicon oxide (SiO), silicon nitride (SiN), or silicon oxynitride (SiON), but embodiments are not limited thereto.

One or more buffer lower pads 630 may be disposed on a lower surface of the buffer substrate 610. One or more buffer upper pads 650 may be disposed on an upper surface of the buffer substrate 610.

The buffer lower pads 630 and the buffer upper pads 650 may include a conductive material. For example, the buffer lower pads 630 and the buffer upper pads 650 may include at least one of copper (Cu), tungsten (W), or aluminum (Al), but embodiments are not limited thereto.

The one or more buffer lower pads 630 may be disposed to be spaced apart from one another. The one or more buffer upper pads 650 may be disposed to be spaced apart from one another.

A side surface of the buffer lower pads 630 may be covered by the buffer lower insulating layer 620. A side surface of the buffer upper pads 650 may be covered by the buffer upper insulating layer 640.

A lower surface of the buffer lower pads 630 may be disposed at the same level as a lower surface of the buffer lower insulating layer 620. An upper surface of the buffer lower pads 630 may be disposed at the same level as an upper surface of the buffer lower insulating layer 620. A lower surface of the buffer upper pads 650 may be disposed at the same level as a lower surface of the buffer upper insulating layer 640. An upper surface of the buffer upper pads 650 may be disposed at the same level as an upper surface of the buffer upper insulating layer 640.

The buffer through-silicon via 660, configured to electrically connect the buffer lower pads 630 and the buffer upper pads 650, may be disposed in the buffer substrate 610. The buffer through-silicon via 660 may be disposed to penetrate through the buffer substrate 610 in a third direction D3. The buffer through-silicon via 660 may electrically connect the buffer lower pads 630 and the buffer upper pads 650, and may allow a memory stack MS to be electrically connected to an external host device.

The buffer through-silicon via 660 may include a conductive material. For example, the buffer through-silicon via 660 may include at least one of copper (Cu), tungsten (W), or aluminum (Al), but embodiments are not limited thereto.

A memory stack MS may be disposed on the buffer die LD. The memory stack MS may include a first core die CD1, a second core die CD2, a third core die CD3, and a fourth core die CD4. For clarity, the memory stack MS is described as including four core dies CD1 to CD4, but embodiments are not limited thereto.

The first core die CD1 may be disposed on the buffer die LD. The first core die CD1 may include a first core substrate 110, a first lower insulating layer 120, a first lower pad 130, a first upper insulating layer 140, a first upper pad 150, and a first through-silicon via 160.

For example, the first core substrate 110 may include a semiconductor material such as silicon (Si) and germanium (Ge). For example, the first core substrate 110 may also include a compound such as silicon carbide (SiC), gallium arsenide (GaAs), indium arsenide (InAs), or indium phosphide (InP). For example, the first core substrate 110 may have a silicon-on-insulator (SOI) structure and may have an isolation structure such as shallow trench isolation (STI).

The first core substrate 110 may have a lower surface and an upper surface opposing one another. For example, the upper surface and the lower surface may refer to surfaces opposing one another with respect to a third direction D3.

A first lower insulating layer 120 may be disposed on the lower surface of the first core substrate 110. A first upper insulating layer 140 may be disposed on the upper surface of the first core substrate 110.

The first lower insulating layer 120 and the first upper insulating layer 140 may include an insulating material. For example, the first lower insulating layer 120 and the first upper insulating layer 140 may include at least one of silicon oxide (SiO), silicon nitride (SiN), or silicon oxynitride (SiON), but embodiments are not limited thereto.

In addition, one or more first lower pads 130 may be disposed on the lower surface of the first core substrate 110. One or more first upper pads 150 may be disposed on the upper surface of the first core substrate 110.

The first lower pads 130 and the first upper pads 150 may include a conductive material. For example, the first lower pads 130 and the first upper pads 150 may include at least one of copper (Cu), tungsten (W), or aluminum (Al), but embodiments are not limited thereto.

The one or more first lower pads 130 may be disposed to be spaced apart from one another. The one or more first upper pads 150 may be disposed to be spaced apart from one another.

A side surface of the first lower pads 130 may be covered by the first lower insulating layer 120. A side surface of the first upper pads 150 may be covered by the first upper insulating layer 140.

A lower surface of the first lower pads 130 may be disposed at the same level as a lower surface of the first lower insulating layer 120. An upper surface of the first lower pads 130 may be disposed at the same level as an upper surface of the first lower insulating layer 120. A lower surface of the first upper pads 150 may be disposed at the same level as a lower surface of the first upper insulating layer 140. An upper surface of the first upper pads 150 may be disposed at the same level as an upper surface of the first upper insulating layer 140.

The first through-silicon via 160, configured to electrically connect the first lower pads 130 and the first upper pads 150, may be disposed in the first core substrate 110. The first through-silicon via 160 may be disposed to penetrate through the first core substrate 110 in the third direction D3. The first through-silicon via 160 may electrically connect the first lower pads 130 and the first upper pads 150. The first through-silicon via 160 may include a conductive material. For example, the first through-silicon via 160 may include at least one of copper (Cu), tungsten (W), or aluminum (Al), but embodiments are not limited thereto.

The first lower insulating layer 120 may be in contact with the buffer upper insulating layer 640. The first lower pad 130 may be in contact with the buffer upper pad 650. In addition, the first lower insulating layer 120 may be bonded to the buffer upper insulating layer 640. The first lower pad 130 may be bonded to the buffer upper pad 650. The first core die CD1 may be bonded to the buffer die LD using an HCB method. The first core die CD1 and the buffer die LD may be electrically connected in a manner in which the first lower pad 130 is brought into contact with the buffer upper pad 650.

The second core die CD2 may be disposed on the first core die CD1. The second core die CD2 may include a second core substrate 210, a second lower insulating layer 220, a second lower pad 230, a second upper insulating layer 240, a second upper pad 250, and a second through-silicon via 260.

The second lower insulating layer 220 may be in contact with the first upper insulating layer 140. The second lower pad 230 may be in contact with the first upper pad 150. In addition, the second lower insulating layer 220 may be bonded to the first upper insulating layer 140. The second lower pad 230 may be bonded to the first upper pad 150. The second core die CD1 may be bonded to the first core die CD1 using an HCB method. The second core die CD2 and the first core die CD1 may be electrically connected in a manner in which the second lower pad 230 is brought into contact with the first upper pad 150.

The third core die CD3 may be disposed on the second core die CD2. The third core die CD3 may include a third core substrate 310, a third lower insulating layer 320, a third lower pad 330, a third upper insulating layer 340, a third upper pad 350, and a third through-silicon via 360.

The third core die CD3 may be bonded to the second core die CD2 using an HCB method. The third core die CD3 and the second core die CD2 may be electrically connected in a manner in which the third lower pad 330 is brought into contact with the second upper pad 250.

The fourth core die CD4 may be disposed on the third core die CD3. The fourth core die CD4 may include a fourth core substrate 410, a fourth lower insulating layer 420, a fourth lower pad 430, a fourth upper insulating layer 440, a fourth upper pad 450, and a fourth through-silicon via 460.

The fourth core die CD4 may be bonded to the third core die CD3 using an HCB method. The fourth core die CD4 and the third core die CD3 may be electrically connected in a manner in which the fourth lower pad 430 is brought into contact with the third upper pad 350.

The second core die to the fourth core die CD2 to CD4 may be configured in the same manner as or a similar manner to the first core die CD1, and thus, a detailed description thereof will be omitted to avoid redundancy.

As described above, one of the core dies may include a first metal pad corresponding to an upper pad and a first insulating layer corresponding to an upper insulating layer and covering a side surface of the first metal pad. Another core die stacked on the one core die may include a second metal pad corresponding to a lower pad and being in contact with the first metal pad, and a second insulating layer corresponding to a lower insulating layer and being in contact with the first insulating layer.

In one or more embodiments, a backup die BD may be disposed on the fourth core die CD4. The backup die BD may include a backup substrate 510, a backup lower insulating layer 520, and a backup lower pad 530.

The backup die BD may be bonded to the fourth core die CD4 using an HCB method. The backup die BD and the fourth core die CD4 may be electrically connected in a manner in which the backup lower pad 530 is brought into contact with the fourth upper pad 450.

The backup die BD may be disposed on an uppermost layer of the memory stack MS, and a configuration of an upper insulating layer, an upper pad, and a through-silicon via may be omitted.

According to the above-described embodiments, when one of the first core die to the fourth core die CD1 to CD4 is determined to be in a bad state based on a fail-bit count, the backup die BD may operate as an ECC die. For example, the backup die BD may store error correction data.

Dies are stacked using an HCB method, so that the memory device 100 according to the above-described embodiments may improve a bonding yield.

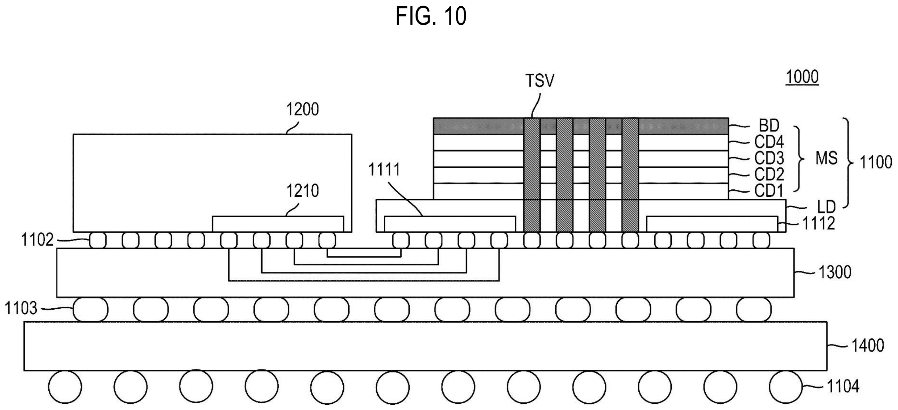

FIG. 10 is a diagram illustrating a memory system according to one or more embodiments.

Referring to FIG. 10, a memory system 1000 may include a memory device 1100, a system-on-chip (SoC) 1200, an interposer 1300, and a package substrate 1400.

The memory device 1100 may be configured according to the above-described embodiments (for example, see FIGS. 1-9). In FIG. 10, the memory device 1100 is illustrated as including a single memory stack MS, but embodiments are not limited thereto. For example, the memory device 1100 may also include a plurality of memory stacks identified through an SID.

The memory device 1100 may receive data and a command address from the system-on-chip 1200 corresponding to a host device.

The memory stack MS may include a plurality of core dies CD1 to CD4 and a backup die BD. The backup die BD may operate as an ECC die or a normal die according to the above-described embodiments.

In one or more embodiments, a logic die LD may include a first physical layer area 1111 and a direct access area 1112. The first physical layer area 1111 may be electrically connected to a second physical layer area 1210 of the system-on-chip 1200 through the interposer 1300. The memory device 1100 may receive a signal from the system-on-chip 1200 or transmit a signal to the system-on-chip 1200 through the first physical layer area 1111.

The first physical layer area 1111 may include an interface for each of the plurality of channels according to the above-described embodiments.

The direct access area 1112 may be configured to provide an access path for testing the memory device 1100 without passing through the system-on-chip 1200. The direct access area 1112 may include a means (for example, a port or a pin) for direct communication with an external test device. A test signal received through the direct access area 1112 may be transmitted to the core dies CD1 to CD4 through through-silicon vias. Data read from the core dies CD1 to CD4 for a test of the core dies CD1 to CD4 may be transmitted to the test device through the through-silicon vias and the direct access area 1112.

Accordingly, a direct access to the core dies CD1 to CD4 may be tested.

The logic die LD, the core dies CD1 to CD4, and the backup die BD may be electrically connected to one another through through-silicon vias TSVs. The logic die LD may receive signals provided to each of the channels through the through-silicon vias allocated for each channel from the system-on-chip 1200, or may transmit signals to the system-on-chip 1200 through the through-silicon vias.

The system-on-chip 1200 may correspond to a host device that generates data and a command address. The system-on-chip 1200 may execute applications supported by the memory system 1000 using the memory device 1100. For example, the system-on-chip 1200 may include at least one processor of a central processing unit (CPU), an application processor (AP), a graphics processing unit (GPU), a neural processing unit (NPU), a tensor processing unit (TPU), a vision processing unit (VPU), an image signal processor (ISP), or a digital signal processor (DSP).

The system-on-chip 1200 may control the overall operation of the memory device 1100. The system-on-chip 1200 may include a memory controller.

In one or more embodiments, the system-on-chip 1200 may receive error correction data from the memory device and may correct an error for one or more dies based on the error correction data.

The system-on-chip 1200 may include a second physical layer area 1210. The second physical layer area 1210 may include an interface circuit for transmitting and receiving signals to and from the first physical layer area 1111 of the memory device 1100. The system-on-chip 1200 may provide various signals to the first physical layer area 1111 through the second physical layer area 1210.

The signals provided to the first physical layer area 1111 may be transmitted to the memory stack through an interface circuit of the first physical layer area 1111 and through-silicon vias TSVs.

The system-on-chip 1200 may be electrically connected to the logic die LD through bumps 1102.

The interposer 1300 may connect the memory device 1100 and the system-on-chip 1200. The interposer 1300 may connect the physical layer 1111 of the memory device 1100 and the physical layer 1210 of the system-on-chip 1200, and may provide physical paths formed using conductive materials. Accordingly, the memory device 1100 and the system-on-chip 1200 may be stacked on the interposer 1300 to transmit and receive signals to and from one another.

Bumps 1103 may be attached to an upper portion of the package substrate 1400, and solder balls 1104 may be attached to a lower portion thereof. For example, the bumps 1103 may be flip-chip bumps. The interposer 1300 may be stacked on the package substrate 1400 through the bumps 1103. The memory system 1000 may transmit and receive signals to and from other external packages or semiconductor devices through the solder balls 1104. For example, the package substrate 1400 may be a printed circuit board (PCB).

As set forth above, according to embodiments, a memory device including a plurality of distributed sub-channels for stacked dies and a memory system including the same may be provided.

While various embodiments have been shown and described above, it will be apparent to those skilled in the art that modifications and variations could be made without departing from the scope of the present disclosed concepts as defined by the appended claims.

Embodiments are set out in the following clauses:
Clause 1. A memory device comprising:
   a logic die;
   a memory stack stacked on the logic die and comprising a plurality of core dies and a backup die electrically connected to the logic die through a plurality of through-silicon vias; and
   a plurality of channels configured to provide communication between the logic die and the memory stack,
   wherein:
      each of the plurality of channels comprises a plurality of sub-channels mapped to the plurality of core dies and the backup die to avoid overlapping one another.
Clause 2. The memory device of clause 1, wherein:
   the backup die stores error correction data when one of the plurality of core dies is determined to be in a bad state based on a fail-bit count, and stores at least one of user data or the error correction data when the plurality of core dies are determined to be in a normal state.
Clause 3. The memory device of clause 1 or 2, wherein:
   when the memory stack is configured as a plurality of memory stacks, each of the plurality of memory stacks is identified through a stack ID (SID), and the backup die is uniquely configured for the SID.
Clause 4. The memory device of any preceding clause, wherein:
   when the memory stack is configured as a plurality of memory stacks, the plurality of sub-channels are mapped for each of the plurality of memory stacks.
Clause 5. The memory device of clause 2, or clause 3 or 4 when dependent on clause 2, wherein:
   one of the plurality of core dies is determined to be in the bad state when the fail-bit count is greater than or equal to a set value.
Clause 6. The memory device of clause 2, or any one of clauses 3 to 5 when dependent on clause 2, wherein:
   one of the plurality of core dies comprises an on-die error correction circuit configured to perform error correction when the fail-bit count is greater than or equal to a set value, and
   one of the plurality of core dies is determined to be in the bad state when error correction through the on-die error correction circuit fails.
Clause 7. The memory device of clause 2, or any one of clauses 3 to 6 when dependent on clause 2, wherein:
   when the backup die stores the error correction data, one of the plurality of sub-channels transmits the error correction data to the logic die.
Clause 8. The memory device of any preceding clause, wherein:
   an input/output width of each of the plurality of sub-channels is defined based on a number of the plurality of core dies.
Clause 9. The memory device of any preceding clause, wherein:
   the plurality of sub-channels transmit data divided from data allocated to one of the plurality of channels.
Clause 10. The memory device of any preceding clause, wherein:
   the plurality of core dies comprise:
   a first core die comprising a first metal pad and a first insulating layer covering a side surface of the first metal pad; and
   a second core die comprising a second metal pad contacting the first metal pad and a second insulating layer contacting the first insulating layer.
Clause 11. A memory system comprising:
   a host device configured to generate data and a command address; and
   a memory device configured to receive the data and the command address from the host device,
   wherein:
      the memory device comprises:
         a logic die;
         a memory stack stacked on the logic die and comprising a plurality of core dies and a backup die electrically connected to the logic die through a plurality of through-silicon vias; and
         a plurality of channels configured to provide communication between the logic die and the memory stack; and
      each of the plurality of channels comprises a plurality of sub-channels mapped to the plurality of core dies and the backup die to avoid overlapping one another.
Clause 12. The memory system of clause 11, wherein:
   the backup die stores error correction data when one of the plurality of core dies is determined to be in a bad state based on a fail-bit count, and stores at least one of user data or the error correction data when the plurality of core dies are determined to be in a normal state.
Clause 13. The memory system of clause 11 or 12, wherein:
   when the memory stack is configured as a plurality of memory stacks, each of the plurality of memory stacks is identified through a stack ID (SID), and the backup die is uniquely configured for the SID.
Clause 14. The memory system of clause 12, or clause 13 when dependent on clause 12, wherein:
   one of the plurality of core dies comprises an on-die error correction circuit configured to perform error correction when the fail-bit count is greater than or equal to a set value, and
   one of the plurality of core dies is determined to be in the bad state when error correction through the on-die error correction circuit fails.
Clause 15. The memory system of clause 12, or clause 13 or 14 when dependent on clause 12, wherein:
   the host device is configured to receive the error correction data from the memory device and to correct an error in the one or more dies based on the error correction data.

## Claims

1. A memory device (100) comprising:
a logic die (LD);
a memory stack (MS) stacked on the logic die (LD) and comprising a plurality of core dies (CD1 ... CDk) and a backup die (BD) electrically connected to the logic die (LD) through a plurality of through-silicon vias (TSV); and
a plurality of channels (CH1 ... CHm) configured to provide communication between the logic die (LD) and the memory stack (MS),
wherein:
each channel of the plurality of channels (CH1 ... CHm) comprises a plurality of sub-channels (S₁₁ ... S₁ₙ; ... Sₘ₁ ... Sₘₙ) mapped to the plurality of core dies (CD) and the backup die (BD) to avoid overlapping one another.

2. The memory device (100 of claim 1, wherein:
the backup die (BD) stores error correction data when one of the plurality of core dies (CD1 ... CDk) is determined to be in a bad state based on a fail-bit count, and stores at least one of user data or the error correction data when the plurality of core dies (CD1 ... CDk) are determined to be in a normal state.

3. The memory device (100) of claim 1 or 2, wherein:
when the memory stack (MS) is configured as a plurality of memory stacks (MS1, MS2), each of the plurality of memory stacks (MS1, MS2) is identified through a stack ID, SID, and the backup die (BD1, BD2) of each memory stack of the plurality of memory stacks (MS1, MS2) is uniquely configured for the SID.

4. The memory device (100) of any preceding claim, wherein:
when the memory stack (MS) is configured as a plurality of memory stacks (MS1, MS2), the plurality of sub-channels (S₁₁ ... S₁ₙ; ... Sₘ₁ ... Sₘₙ) are mapped for each memory stack of the plurality of memory stacks (MS1, MS2).

5. The memory device (100) of claim 2, or claim 3 or 4 when dependent on claim 2, wherein:
one of the plurality of core dies (CD1 ... CDk) is determined to be in the bad state when the fail-bit count is greater than or equal to a set value.

6. The memory device (100) of claim 2, or any one of claims 3 to 5 when dependent on claim 2, wherein:
each core die of the plurality of core dies (CD1 ... CDk) comprises a corresponding on-die error correction circuit (OEC1 ... OECk) configured to perform error correction when the corresponding fail-bit count is greater than or equal to a set value, and
each core die of the plurality of core dies (CD1 ... CDk) is determined to be in the bad state when error correction through the corresponding on-die error correction circuit (OEC1 ... OECk) fails.

7. The memory device (100) of claim 2, or any one of claims 3 to 6 when dependent on claim 2, wherein:
when the backup die (BD) stores the error correction data, one sub-channel of the plurality of sub-channels (S₁₁ ... S₁ₙ; ... Sₘ₁ ... Sₘₙ) transmits the error correction data to the logic die (LD).

8. The memory device (100) of any preceding claim, wherein:
an input/output width of each sub-channel of the plurality of sub-channels (S₁₁ ... S₁ₙ; ... Sₘ₁ ... Sₘₙ) is defined based on a number of the plurality of core dies (CD1 ... CDk).

9. The memory device (100) of any preceding claim, wherein:
the plurality of sub-channels (S₁₁ ... S₁ₙ; ... Sₘ₁ ... Sₘₙ) transmit data divided from data allocated to one of the plurality of channels (CH1 ... CHm).

10. The memory device (100) of any preceding claim, wherein:
the plurality of core dies (CD1 ... CDk) comprise:
a first core die (CD1) comprising a first metal pad (150) and a first insulating layer (140) covering a side surface of the first metal pad (150); and
a second core die (CD2) comprising a second metal pad (230) contacting the first metal pad (150) and a second insulating layer (220) contacting the first insulating layer (140).

11. A memory system (1000) comprising:
a host device (1200) configured to generate data and a command address; and
the memory device (1100) of claim 1, wherein the memory device (1100) is configured to receive the data and the command address from the host device (1200).

12. The memory system (1000) of claim 11, wherein:
the backup die (BD) stores error correction data when one of the plurality of core dies (CD1 ... CD4) is determined to be in a bad state based on a fail-bit count, and stores at least one of user data or the error correction data when the plurality of core dies (CD1 ... CD4) are determined to be in a normal state.

13. The memory system (1000) of claim 11 or 12, wherein:
when the memory stack (MS) is configured as a plurality of memory stacks (MS1, MS2), each of the plurality of memory stacks (MS1, MS2) is identified through a stack ID, SID, and the backup die (BD1, BD2) of each memory stack of the plurality of memory stacks (MS1, MS2) is uniquely configured for the SID.

14. The memory system (1000) of claim 12, or claim 13 when dependent on claim 12, wherein:
each core die of the plurality of core dies (CD1 ... CD4) comprises a corresponding on-die error correction circuit configured to perform error correction when the corresponding fail-bit count is greater than or equal to a set value, and
each core die of the plurality of core dies (CD1 ... CD4) is determined to be in the bad state when error correction through the corresponding on-die error correction circuit fails.

15. The memory system (1000) of claim 12, or claim 13 or 14 when dependent on claim 12, wherein:
the host device (1200) is configured to receive the error correction data from the memory device (1100) and to correct an error in the one or more dies based on the error correction data.
